# EUROPÄISCHE PATENTSCHRIFT

(11) **EP 1 042 849 B1**
(45) Veröffentlichungstag und Bekanntmachung des Hinweises auf die Patenterteilung: **12.06.2002**
(21) Anmeldenummer: 98966189.7
(22) Anmeldetag: 26.11.1998
(51) Int. Cl.: H01S 5/40, H04B 10/14

(54) **MEHRKANALIGE OPTISCHE SENDEEINRICHTUNG**
MULTICHANNEL OPTICAL TRANSMITTER
DISPOSITIF EMETTEUR OPTIQUE A PLUSIEURS CANAUX

(30) Priorität: 28.11.1997 DE 19754770
(43) Veröffentlichungstag der Anmeldung: 11.10.2000
(73) Patentinhaber: Infineon Technologies AG, 81669 München (DE)
(72) Erfinder: STAUDEMEYER, Nhu-Phuong, D-13629 Berlin (DE); PLICKERT, Volker, D-14656 Brieselang (DE); MELCHIOR, Lutz, D-12559 Berlin (DE)
(74) Vertreter: Maikowski, Michael, Dipl.-Ing. Dr.
(86) Internationale Anmeldenummer: DE9803550
(87) Internationale Veröffentlichungsnummer: WO9929000

(56) Entgegenhaltungen:
- DE-A- 19 650 853
- DE-C- 4 313 492
- US-A- 5 757 829
- US-A- 5 784 396

## Beschreibung

Die Erfindung liegt auf dem Gebiet mehrkanaliger optischer Sendeeinrichtungen, insbesondere zur parallelen mehrkanaligen Datenübertragung mittels entsprechend mehrerer Lichtwellenleiter, und betrifft eine Sendeeinrichtung mit einer Sendeeinheit, die mehrere in einer Reihe angeordnete Nutzlaser umfaßt, wobei die optisch aktiven Zonen der Nutzlaser bei Ansteuerung Nutzstrahlung vertikal zur Deckfläche der Sendeeinheit emittieren und mit einer Monitoreinheit zur Leistungsüberwachung, die zumindest einen an der Reihe der Nutzlaser angeordneten Überwachungslaser umfaßt, dessen optisch aktive Zone bei Ansteuerung vertikal zu derselben Deckfläche der Sendeeinheit Strahlung emittiert, die zumindest teilweise auf eine strahlungssensitive Fläche eines Monitorempfängers gelangt.

Im Zusammenhang mit Lasersendern ist bekannt (EP 0622874 A1), daß die von dem Laser abgestrahlte Lichtleistung insbesondere temperatur- und alterungsabhängigen Schwankungen unterliegt. Im Hinblick auf die Lasersicherheit muß außerdem sichergestellt sein, daß aus einer von außen zugänglichen optischen Schnittstelle (sogenannter optischer Port) austretendes Laserlicht unterhalb eines Leistungsgrenzwertes bleibt. Im Falle einer unzulässigen Erhöhung der Laserleistung über diesen Grenzwert beispielsweise infolge eines Fehlers der elektronischen Ansteuerschaltung muß eine zuverlässige Abschaltung des Lasers erfolgen. Zu den vorgenannten Zwecken sind Regelungseinrichtungen üblich, die die Ansteuerung des Lasers zur Erzielung einer konstanten und unterhalb zulässiger Grenzwerte liegenden Ausgangsleistung nachregeln. Dazu muß die optische Leistung überwacht werden. In der EP 0622874 A1 ist dazu eine Regelung der temperatur- und alterungsabhängigen Lichtleistung eines kantenemittierenden Lasers offenbart, an dessen rückwärtigen Abstrahlbereich eine Überwachungs- oder Monitordiode angekoppelt ist. Die Ankopplung erfolgt über eine in einem gemeinsamen Träger angeordnete Vertiefung, an der die rückwärtig emittierte Strahlung über zumindest eine Spiegelfläche auf die optisch sensitive Zone der Monitordiode gelangt. Dieser bekannte Aufbau ist jedoch für die Überwachung und Regelung von vertikal zur Deckfläche abstrahlende Lasereinrichtungen (sog. VCSEL) ungeeignet.

Aus der internationalen Patentanmeldung WO 97/25638 ist eine mehrkanalige optische Sendeeinrichtung der eingangs genannten Art bekannt, deren Sendeeinheit von einem Laserarray gebildet ist, das mehrere in einer Reihe angeordnete einzeln ansteuerbare Nutzlaser enthält. Die optisch aktiven Zonen der Nutzlaser sind derart ausgebildet, daß ihre Nutzstrahlung vertikal zur Deckfläche austritt. Die emittierte Strahlung des ersten Halbleiterlasers der Reihe wird dagegen nicht als Nutzstrahlung verwendet, sondern dient zur Regelung des Ansteuerstroms aller Halbleiterlaser. Dieser erste eine Laser fungiert damit als Überwachungslaser; dessen Strahlung gelangt durch eine Vertiefung an der dem Laserarray zugewandten Seite eines Grundkörpers durch mehrfache Reflektion auf die strahlungssensitive Fläche eines neben dem Laserarray angeordneten Monitorempfängers. Der Monitorempfänger ist im wesentlichen auf derselben Ebene wie das Laserarray angeordnet.

Diese bekannte Sendeeinrichtung erlaubt eine zuverlässige Regelung der Laserausgangsleistungen, wobei sich jedoch die mehrfache Umlenkung der Strahlung des Überwachungslasers und die Montage als problematisch erweisen können. In Fällen, in denen ein vollständiger Verguß der Sendeeinrichtung erwünscht ist, besteht die Gefahr, daß sich an den Umlenkspiegeln Lufteinschlüsse bilden, die den Koppelwirkungsgrad verringern. Insgesamt steht nur ein vergleichsweise geringer Anteil der überwachungslaserseitig emittierten Strahlung für Regelungszwecke zur Verfügung.

Die Aufgabe der Erfindung besteht daher in der Weiterbildung einer Sendeeinrichtung dahingehend, daß ein vergleichsweise hoher Kopplungswirkungsgrad zwischen dem Überwachungslaser und dem Monitorempfänger bei gleichzeitig einfachem und fertigungsfreundlichem Aufbau der Sendeeinrichtung gewährleistet ist.

Diese Aufgabe wird erfindungsgemäß bei einer Sendeeinrichtung der eingangs genannten Art dadurch gelöst, daß der Monitorempfänger auf einer Ebene angeordnet ist, die oberhalb der Deckfläche der Sendeeinheit liegt, und daß der Monitorempfänger den Überwachungslaser kragträgerartig derart überragt, daß seine strahlungssensitive Fläche der optisch aktiven Zone des Überwachungslasers gegenüberliegt.

Der Überwachungslaser sollte möglichst weitestgehend identische elektro-optische Eigenschaften insbesondere hinsichtlich des Temperatur und Alterungsverhaltens haben wie die Nutzlaser. Dies läßt sich in vorteilhafter Weise besonders einfach dadurch erreichen, daß der Überwachungslaser Bestandteil der Sendeeinheit ist. Mit anderen Worten wird eine Sendeeinheit (vorzugsweise ein Laserarray) verwendet, bei dem nicht alle aktivierbaren Einzellaser als Nutzlaser verwendet werden, sondern zumindest einer der Laser als Überwachungslaser dient.

Ein wesentlicher Vorteil der Erfindung besteht darin, daß eine zuverlässige Regelung der Sendeeinrichtung mit vergleichsweise wenigen, einfach herzustellenden und zu montierenden Bauelementen möglich ist. Die Monitorempfängeranordnung kann vorteilhafterweise unabhängig von der Sendeeinheit montiert und vorab geprüft werden. Ein weiterer erheblicher Vorteil der erfindungsgemäßen Sendeeinrichtung besteht darin, daß eine nahezu hundertprozentige Überkopplung der Überwachungslaserleistung auf den Monitorempfänger möglich ist. Dadurch kann eine sehr effektive Regelung der Sendeeinrichtung erreicht werden. Ein vorteilhafter Aspekt der Einrichtung besteht darin, daß der optisch aktiven Zone des Überwachungslasers eine bezogen auf diese Zone vergleichsweise große strahlungssensitive Fläche des Monitorempfängers gegenüberliegt; dies erlaubt hinsichtlich der Monitormontage vergleichsweise große Lagetoleranzen. Schließlich kommt die erfindungsgemäße Sendeeinrichtung bei der optischen Kopplung zwischen Überwachungslaser und Monitorempfänger ohne zusätzliche optische abbildende oder spiegelnde Elemente aus, was zu einer erheblichen Senkung des Fertigungsaufwandes beiträgt.

Eine fertigungstechnisch bevorzugte Ausgestaltung der erfindungsgemäßen Sendeeinrichtung sieht vor, daß elektrische Anschlüsse des Monitorempfängers auf derselben Seite wie die strahlungssensitive Fläche liegen.

Dies ermöglicht die Montage und Kontaktierung des Monitorempfängers in sogenannter Flip-Chip-Technik, wobei vorteilhafterweise Selbstzentierungseffekte mittels zuvor auf korrespondierende Kontaktflächen aufgebrachter Lot-Bumps ausgenutzt werden können.

Um die Sendeeinrichtung gegenüber Umwelteinflüssen zu schützen sieht eine vorteilhafte Weiterbildung der Erfindung vor, daß der Raum zwischen der optisch aktiven Zone des Überwachungslasers und der strahlungssensitiven Fläche des Monitorempfängers mit einem für die emittierte Strahlung durchlässigen Kunststoff ausgefüllt ist.

Eine weitere Reduzierung der erforderlichen Einzelteile der erfindungsgemäßen Sendeeinrichtung läßt sich nach einer vorteilhaften Fortbildung der Erfindung dadurch erreichen, daß die Sendeeinheit auf einer unteren Montageebene und der Monitorempfänger auf einer seitlich darüberliegenden Montageebene eines gemeinsamen Trägers angeordnet sind. Der Träger weist Montageflächen in unterschiedlichen Höhen auf, wobei der Monitorempfänger auf der Montagefläche mit dem höheren Niveau vorzugsweise in Flip-Chip-Technik unter Ausnutzung des Selbstjustageeffekts bei der Lot-Bump-Montage kontaktiert wird. Eine besonders zuverlässige Regelung unter Verwendung symmetrischer Regeleingangsignale läßt sich nach einer bevorzugten Ausgestaltung der Erfindung dadurch erreichen, daß an die Reihe der Nutzlaser anschließend jeweils eine Monitoreinheit mit einem Überwachungslaser und einem Monitorempfänger angeordnet ist, dessen strahlungssensitive Fläche der optisch aktiven Zone des jeweiligen Überwachungslasers zugewandt ist.

Ausführungsbeispiele einer erfindungsgemäßen Sendeeinrichtung werden nachfolgend anhand einer Zeichnung erläutert; es zeigen:
Figuren 1, 2 und 3 eine erste Sendeeinrichtung in teilweiser Aufsicht, im Längsschnitt entlang der Linie II-II und im Querschnitt entlang der Linie III-III; und die
Figuren 4 bis 6 ein zweites Ausführungsbeispiel in gleicher Aufsicht- und Schnittdarstellung.

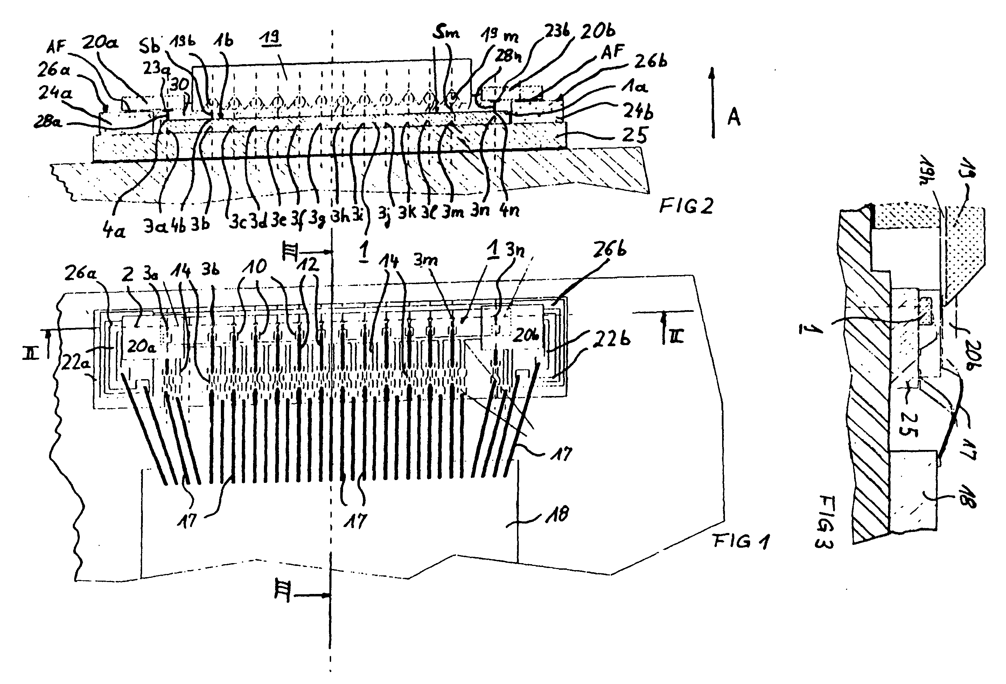

Gemäß den Figuren 1 bis 3 enthält die mehrkanalige optische Sendeeinrichtung eine Sendeeinheit 1, die als Laserarray ausgebildet ist und mehrere in einer Reihe 2 angeordnete einzelne Halbleiterlaser 3a bis 3n umfaßt. Die Laser sind in an sich bekannter Weise in integraler Aufbautechnik erzeugt und haben jeweils eine optisch aktive Zone 4a, 4b und entsprechend bis 4n. Die optisch aktiven Zonen 4a bis 4n sind in einer oberen Deckschicht 1a der Sendeeinheit 1 ausgebildet und emittieren bei elektrischer Ansteuerung Nutzstrahlung in vertikaler Richtung A (Figur 2) aus einer Deckläche 1b nach oben. Die Ansteuerung der einzelnen Laser erfolgt in an sich bekannter Weise über auf der Deckfläche 1b der Sendeeinheit 1 ausgebildete Anschlußflecken 10 und über mit diesen über Bonddrähte 12 kontaktierte Leiterbahnen 14 mit weiteren Anschlußflecken 16. Mit den weiteren Anschlußflecken sind einerseits die Bonddrähte 12 und andererseits weitere Bonddrähte 17 verbunden, die Bondbrücken zu einem nur andeutungsweise dargestellten Regelungs- und Ansteuer-IC 18 bilden.

Die Halbleiterlaser 3b bis 3m sind derart in Bezug auf Lichtwellenleiterenden 19b bis 19m einer Koppelbaugruppe 19 angeordnet, daß von ihnen emittierte Strahlung Sb bis Sm in die Lichtwellenleiterenden eintritt. Diese Strahlung wird daher nachfolgend auch als Nutzstrahlung und die entsprechenden Laser 3b bis 3m als Nutzlaser bezeichnet. Durch Modulation der emittierten Strahlung lassen sich optische Signale erzeugen und zur Weiterleitung in die Enden der Lichtwellenleiter 19b bis 19m einspeisen.

Um die Nutzstrahlungsleistung der Laser 3b bis 3m zu regeln, ist die Sendeeinrichtung mit einer an sich bekannten, nicht dargestellten elektronischen Regelung versehen, die in dem Schaltkreis 18 integriert ist. Als Eingangsgröße für diese Regelung dienen von zwei Monitorempfängern 20a, 20b gelieferte und über Leiterbahnen 22a, 22b und Bonddrähte dem Schaltkreis 18 zugeführte Ausgangssignale. Die Ausgangssignale stehen in Zusammenhang mit der Strahlungsintensität oder Strahlungsleistung, die auf eine optisch sensitive Fläche 23a, 23b der Monitorempfänger 20a, 20b trifft. Der Monitorempfänger 20a, 20b ist jeweils auf einem separaten Träger 24a, 24b in Flip-Chip-Montagetechnik kontaktiert und fixiert. Dabei wirken korrespondierende Anschlußflecken AF auf der Unterseite der Monitorempfänger und des jeweiligen Trägers 24a, 24b unter Zwischenlage von Lotkugeln (Lot-Bumps) zusammen. Beim Wiedererhitzen des Lotes gelangen die Lotkugeln mit den Anschlußflecken beider Bauelemente in Kontakt und führen dadurch zu einer Selbstjustage der Monitorempfänger 20a, 20b in Bezug auf den jeweiligen Träger. Auf derselben Unterseite der Monitorempfänger sind auch die photosensitiven Flächen 23a, 23b ausgebildet. Die Träger 24a, 24b sind auf einem Hauptträger 25 befestigt, der auch Träger der Sendeeinheit 1 ist.

Wie insbesondere Figur 2 deutlich zeigt, ist jeder Monitorempfänger auf einer erhöhten, seitlich der Sendeeinheit 1 ausgebildeten Montageebene 26a, 26b als Kragträgers so angeordnet, daß die strahlungssensitive Fläche 23a, 23b unter Bildung eines Zwischenraumes der optisch aktiven Zone 4a, 4n der Laser 3a, 3n gegenüberliegt. Der auf dem jeweiligen Träger aufgebrachte Monitorempfänger kann damit unabhängig von der Sendeeinheit montiert und aufgrund seiner unabhängigen Kontaktierung auch individuell geprüft werden. Die beidendig der Reihe 2 angeordneten Laser 3a, 3n fungieren somit nicht als Nutzlaser, sondern als Überwachungslaser, deren emittierte Strahlung auf den jeweiligen zugeordneten Monitorempfänger trifft und damit zur Regelung der optischen Ausgangsleistung der gesamten Sendeeinrichtung dient. Die Ausgestaltung der Monitorempfängerbaugruppen bietet außerdem den Vorteil, daß der Strahlungsverlauf zwischen der aktiven Zone 4a, 4n und der zugeordneten strahlungssensitiven Fläche 23a, 23b unmittelbar und gradlinig ohne Zwischenschaltung zusätzlicher optisch abbildender und/oder reflektierender Elemente in vergleichsweise kurzer Strecke erfolgt. Da außerdem die strahlungssensitive Fläche im Vergleich zu den optisch aktiven Zonen relativ groß ausgebildet ist, ergibt sich eine relativ große Lagetoleranz des Monitorempfängers gegenüber dem jeweiligen Überwachungslaser. Insgesamt wird dadurch ein hoher Kopplungswirkungsgrad und damit eine sehr effiziente Regelung der Laserausgangsleistungen geschaffen. Zum Schutz ist der Raum zwischen der jeweiligen optisch aktiven Zone 4a, 4n und der strahlungssenitiven Fläche 23a, 23b mit einem für die emittierte Strahlung 28a, 28n der Laser 4a, 4n durchlässigen Kunststoff 30 ausgefüllt.

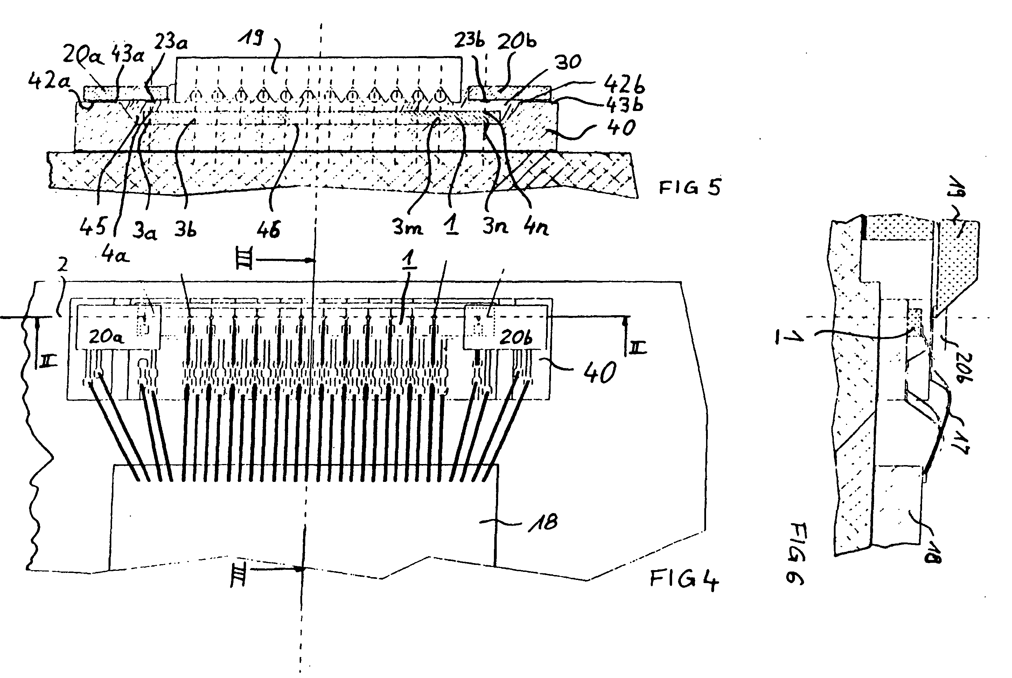

Die Figuren 4 bis 6 zeigen eine Variante der Sendeeinrichtung, die in ihrem prinzipiellen Aufbau und in ihrem optischen bzw. elektrischen Anschluß der in den Figuren 1 bis 3 gezeigten Einrichtung entspricht. Es werden daher für gleiche Elemente auch dieselben Bezugszeichen verwendet. Die Variante besteht im wesentlichen darin, daß ein einziger Träger 40 vorgesehen ist, der sowohl die Sendeeinheit 1 mit ihren individuellen Lasern 3a bis 3n als auch den jeweiligen Monitorempfänger 20a, 20b trägt. Die Monitorempfänger sind in beschriebener Flip-Chip-Montagetechnik über Lot-Bumps 42a, 42b unmittelbar auf einer oberen Montageebene 43a, 43b des Trägers 40 montiert. Der Träger besteht vorzugsweise aus anisotrop geätztem Silizium in <100>-Orientierung und weist eine geätzte Montagewanne 45 auf. Auf dem Boden 46 der Montagewanne liegt die Sendeeinheit 1. Diese Konstruktion ermöglicht in weiterer fertigungstechnischer Vereinfachung und Reduzierung der erforderlichen Bauteile ebenfalls eine Montage der Monitorempfänger 20a, 20b derart, daß die strahlungssensitiven Flächen 23a, 23b auf die optisch aktiven Zonen 4a, 4n der Überwachungslaser 3a, 3n ausgerichtet sind und die Monitorempfänger den jeweiligen Überwachungslaser kragträgerartig überragen.

## Patentansprüche

1. Mehrkanalige optische Sendeeinrichtung,
- mit einer Sendeeinheit (1), die mehrere in einer Reihe (2) angeordnete Nutzlaser (3b bis 3m) umfaßt,
- wobei die optisch aktiven Zonen (4b bis 4m) der Nutzlaser (3b bis 3m) bei Ansteuerung Nutzstrahlung vertikal zur Deckfläche (1b) der Sendeeinheit (1) emittieren, und mit einer Monitoreinheit zur Überwachung,
- die zumindest einen an der Reihe (2) der Nutzlaser (3b bis 3m) angeordneten Überwachungslaser (3a) umfaßt, dessen optisch aktive Zone (4a) bei Ansteuerung vertikal zu derselben Deckfläche (1b) der Sendeeinheit (1) Strahlung (28a) emittiert, die zumindest teilweise auf eine strahlungssensitive Fläche (23a) eines Monitorempfängers (20a) gelangt,
**dadurch gekennzeichnet, daß**
- der Monitorempfänger (20a) auf einer Ebene (26a) angeordnet ist, die oberhalb der Deckfläche (1b) der Sendeeinheit (1) liegt, und
- der Monitorempfänger (20a) den Überwachungslaser (3a) kragträgerartig derart überragt, daß seine strahlungssensitive Fläche (23a) der optisch aktiven Zone (4a) des Überwachungslasers (3a) gegenüberliegt.

2. Sendeeinrichtung nach Anspruch 1,
**dadurch gekennzeichnet, daß**
elektrische Anschlüsse (AF) des Monitorempfängers (20a) auf derselben Seite wie die strahlungssensitive Fläche (23a) liegen.

3. Sendeeinrichtung nach Anspruch 1 oder 2,
**dadurch gekennzeichnet, daß**
der Raum zwischen der optisch aktiven Zone (4a) des Überwachungslasers (3a) und der strahlungssensitiven Fläche (23a) des Monitorempfängers (20a) mit einem für die emittierte Strahlung (28a) durchlässigen Kunststoff (30) ausgefüllt ist.

4. Sendeeinrichtung nach einem der vorangehenden Ansprüche,
**dadurch gekennzeichnet, daß**
die Sendeeinheit (1) auf einer unteren Montageebene (46) und der Monitorempfänger (20a) auf einer seitlich darüberliegenden Montageebene (42a) eines gemeinsamen Trägers (40) angeordnet sind.

5. Sendeeinrichtung nach einem der vorangehenden Ansprüche,
**dadurch gekennzeichnet, daß**
an die Reihe (2) der Nutzlaser (3b...3m) anschließend jeweils eine Monitoreinheit mit einem Überwachungslaser (3a; 3n) und einem Monitorempfänger (20a; 20b) angeordnet ist, dessen strahlungssensitive Fläche (23a; 23b) der optisch aktiven Zone (4a; 4n) des jeweiligen Überwachungslasers (3a; 3n) zugewandt ist.

## Claims

1. Multichannel optical transmission device,
- having a transmission unit (1) comprising a plurality of useful lasers (3b to 3m) arranged in a row (2),
- where the optically active zones (4b to 4m) of the useful lasers (3b to 3m), when driven, emit useful radiation vertically with respect to the covering area (1b) of the transmission unit (1), and having a monitor unit for monitoring,
- which comprises at least one monitoring laser (3a) arranged on the row (2) of useful lasers (3b to 3m), the optically active zone (4a) of which monitoring laser, when driven, emits radiation (28a) vertically with respect to the same covering area (1b) of the transmission unit (1), which radiation at least partly passes to a radiation-sensitive area (23a) of a monitor receiver (20a),
**characterized in that**
- the monitor receiver (20a) is arranged on a plane (26a) lying above the covering area (1b) of the transmission unit (1), and
- the monitor receiver (20a) projects above the monitoring laser (3a) like a cantilever support in such a way that its radiation-sensitive area (23a) is opposite the optically active zone (4a) of the monitoring laser (3a).

2. Transmission device according to Claim 1,
**characterized in that**
electrical connections (AF) of the monitor receiver (20a) lie on the same side as the radiation-sensitive area (23a).

3. Transmission device according to Claim 1 or 2,
**characterized in that**
the space between the optically active zone (4a) of the monitoring laser (3a) and the radiation-sensitive area (23a) of the monitor receiver (20a) is filled with a plastic (30) which is transmissive to the emitted radiation (28a).

4. Transmission device according to one of the preceding claims,
**characterized in that**
the transmission unit (1) is arranged on a lower mounting plane (46) and the monitor receiver (20a) is arranged on a laterally superior mounting plane (42a) of a common support (40).

5. Transmission device according to one of the preceding claims,
**characterized in that**
adjoining the row (2) of useful lasers (3b...3m) there is arranged in each case a monitor unit with a monitoring laser (3a; 3n) and a monitor receiver (20a; 20b) whose radiation-sensitive area (23a; 23b) faces the optically active zone (4a; 4n) of the respective monitoring laser (3a; 3n).

## Revendications

1. Dispositif émetteur optique à plusieurs canaux
- doté d'une unité émettrice (1) qui comprend plusieurs lasers utiles (3b à 3m) disposés en série,
- dans lequel les zones optiquement actives (4b à 4m) des lasers utiles (3b à 3m) émettent, lorsqu'elles sont excitées, un rayonnement utile verticalement par rapport à la surface (1b) de l'unité émettrice (1) et doté d'un moniteur de contrôle,
- qui comprend au moins un laser de contrôle (3a), disposé dans la série des lasers utiles (3b à 3m), dont la zone optiquement active (4a) émet, lorsqu'elle est excitée, un rayonnement (28a) verticalement par rapport à la même surface (1b) de l'unité émettrice (1), sachant qu'une partie au moins de ce rayonnement atteint une surface sensible au rayonnement (23a) d'un récepteur de contrôle (20a),
**caractérisé en ce que**
- le récepteur de contrôle (20a) est disposé sur un plan (26a) situé au-dessus de la surface (1b) de l'unité émettrice (1) et
- le récepteur de contrôle (20a) surplombe le laser de contrôle (3a) en porte-à-faux de telle façon que la surface (23a) sensible au rayonnement du récepteur se trouve en face de la zone optiquement active (4a) du laser de contrôle.

2. Dispositif émetteur selon la revendication 1,
**caractérisé en ce que** les raccordements électriques (AF) du récepteur de contrôle (20a) se trouvent du même côté que la surface sensible au rayonnement (23a).

3. Dispositif émetteur selon la revendication 1 ou 2
**caractérisé en ce que** l'espace séparant la zone optiquement active (4a) du laser de contrôle (3a) et la surface sensible au rayonnement (23a) du récepteur de contrôle (20a) est comblé avec une matière synthétique pouvant être traversée par le rayonnement émis.

4. Dispositif émetteur selon l'une des revendications précédentes **caractérisé en ce que** l'unité émettrice (1) est disposée sur un plan de montage inférieur (46) et le récepteur de contrôle (20a) sur un plan de montage (42a), positionné latéralement et au-dessus du premier, les deux plans étant montés sur un support commun (40).

5. Dispositif émetteur selon l'une des revendications précédentes **caractérisé en ce que** l'on trouve, de part et autre de la série (2) des lasers utiles (3b...3m), une unité de contrôle comprenant un laser de contrôle (3a ; 3n) et un récepteur de contrôle (20a ; 20b), dont la zone sensible au rayonnement (23a ; 23b) est en face de la zone optiquement active (4a ; 4n) du laser de contrôle correspondant (3a ; 3n).
